# EUROPÄISCHE PATENTSCHRIFT

(11) **EP 1 955 370 B1**
(45) Veröffentlichungstag und Bekanntmachung des Hinweises auf die Patenterteilung: **08.01.2014**
(21) Anmeldenummer: 06819273.1
(22) Anmeldetag: 06.11.2006
(51) Int. Cl.: H01L 21/68, C09J 7/02

(54) **VERFAHREN ZUM BEARBEITEN EINES WAFERS**
METHOD FOR PROCESSING A WAFER
PROCEDE POUR USINER UNE TRANCHE DE SEMI-CONDUCTEUR

(30) Priorität: 21.11.2005 DE 102005055769
(43) Veröffentlichungstag der Anmeldung: 13.08.2008
(73) Patentinhaber: TESA SE, 20253 Hamburg (DE)
(72) Erfinder: KEITE-TELGENBÜSCHER, Klaus, 22529 Hamburg (DE); UTESCH, Nils, 201107 Shanghai (CN); ZÖLLNER, Stephan, 21244 Buchholz /Nordheide (DE); KRAWINKEL, Thorsten, 22457 Hamburg (DE)
(86) Internationale Anmeldenummer: PCT/EP2006/068140
(87) Internationale Veröffentlichungsnummer: WO 2007/057318

(56) Entgegenhaltungen:
- EP-A2- 0 977 254
- US-A- 5 030 308
- US-A1- 2004 213 973

## Beschreibung

Die Erfindung betrifft ein Verfahren zum Bearbeiten eines Wafers, wobei das Schichtmaterial besonders zur Fixierung von Bauteilen mit stark strukturierten Oberflächen oder an stark strukturierten Untergründen geeignet ist und das bevorzugt eine sehr hohe Temperaturbeständigkeit aufweist.

Das Schichtmaterial soll es insbesondere erleichtern, die bei der Herstellung von Halbleiterprodukten verwendeten Wafer dünner zu fertigen. Dabei sollen die Wafer vorzugsweise sicherer zu bearbeiten sein, und/oder der notwendige Fertigungsaufwand beim Herstellen von Halbleiterbauelementen, Schaltungen, Sensoren und/oder anderen Halbleiterprodukten reduziert und/oder kostengünstiger gestaltet, und/oder der Einsatz von Laserstrahlschneidverfahren ermöglicht oder erleichtert, und/oder insbesondere die Beschichtung und/oder Strukturierung der Rückseite des gedünnten Wafers ermöglicht oder erleichtert, und/oder die Gefahr des Bruches und/oder der mechanischen Beschädigungen reduziert werden.

Häufig besteht die technische Notwendigkeit, Oberflächen temporär abzudecken, um sie für einen Transport oder nächste Verarbeitungsschritte zu schützen oder zu stützen. Eine weit verbreitete Methode besteht zum Beispiel darin, Teile von Autos mit einer Klebfolie abzudecken, um die Lackierung auf dem Transport zum Kunden zu schützen oder Fahrzeuge vorübergehend mit Werbeaufdrucken zu versehen. Weiterhin finden temporäre Abdeckfolien in der Lackierung (Reparaturlackierung) weite Verbreitung, um Bereiche um Reparaturstellen abzudecken.

Bei der Herstellung von Halbleiterbauteilen (dies(dices)) auf Wafern werden heute ebenfalls vielfach Klebefolien (zum Beispiel so genannte Grindingfolien oder Blue Tapes) zur temporären Abdeckung verwendet, um das Handling für die Rückseitenbearbeitung beziehungsweise das Trennen (Vereinzeln durch Schneiden) einfacher gestalten zu können und außerdem insbesondere die Wafervorderseite, auf der sich die eigentlichen elektronischen Bauelemente befinden, zu schützen.

Die Entwicklung im Bereich der Halbleiterfertigung bewegt sich derzeit in eine Richtung, die darauf abzielt, den Siliziumwafer und damit den Träger der eigentlichen elektronischen Bauelemente und Schaltungen nach dessen Herstellung sehr stark zu abzudünnen. Dabei können heute Dicken von weniger als 20 nm erreicht werden. Die vielfältigen Vorteile, die ein solches Vorgehen mit sich bringt, sollen, obwohl sie sehr weitreichend sind, hier nicht näher dargestellt werden. Als Beispiel sei jedoch angeführt, dass bei geringer Dicke des Wafers - und damit auch der daraus herausgetrennten Mikroplättchen (Die) - das unerwünschte Übersprechen (Cross-talking) zwischen den elektronischen Bauelementen innerhalb des Mikroplättchens sowie das Substratrauschen beispielsweise mit Hilfe einer Rückseitenmetallisierung wirkungsvoll verringert werden kann. Dieser Effekt beruht unter anderem darauf, dass mit abnehmender Dicke der Siliziumschicht auch der Eigenwiderstand der Siliziumschicht abnimmt. Zudem besitzt ein dünner Wafer eine höhere Wärmeleitfähigkeit als ein dicker Wafer, was für den späteren Einsatz gewünscht ist.

Aus der geringen Dicke entstehen jedoch nicht nur Vorteile, sondern es entstehen auch Schwierigkeiten, insbesondere bei der weiteren Verarbeitung der Wafer. Ein stark gedünnter Wafer wird zunehmend labil beziehungsweise verbiegt sich durch Spannung in der Funktionsbeschichtung. Außerdem besitzt er nur noch eine sehr geringe Wärmekapazität. Dadurch entstehen für die nachfolgenden Bearbeitungsschritte große Schwierigkeiten und Herausforderungen. Dies betrifft insbesondere die Rückseitenmetallisierung, bei der Temperaturen von etwa 350 °C aufgewendet werden müssen und zusätzlich eine Vakuumverträglichkeit des zu beschichtenden Wafers zu gewährleisten ist. Die stark verringerte Masse und damit die ebenfalls stark verringerte Wärmekapazität des Wafers führen dazu, dass die elektrischen Schaltungen erheblich stärker durch die hohen Metallisierungstemperaturen belastet werden.

Darüber hinaus stellt das Handling sehr stark gedünnter Wafer in den üblichen hochautomatisierten Prozessen eine Herausforderung aus dem Gesichtspunkt der mechanischen Belastung und der Weiterverarbeitbarkeit in vorhandenen Handlingseinrichtungen dar.

Die Verfahrensweise bei der Herstellung dünner Wafer und/oder dünner Halbleiterbauelemente weicht in der Regel von Anwender zu Anwender ab. Generell wird jedoch wie folgt verfahren. Bei der Herstellung von elektronischen Bauelementen und Schaltungen (Dioden, Transistoren, ICs, Sensoren etc.) werden auf Wafern (Scheiben aus Silizium, GaAs oder anderen Halbleitermaterialen und Substraten) mittels verschiedener Technologien Bauelemente wie zum Beispiel Strukturen, Schichten u. a. aufgebracht. Gegenwärtig werden diese Wafer nach Abschluss der hierzu notwendigen Fertigungsschritte auf der Vorderseite (aktive Seite, das heißt die Seite, auf der sich die aufgebrachten Bauelemente befinden) mit einer Schutzfolie oder einer sonstigen Schutzschicht (wie zum Beispiel eine mittels Wachs kontaktierte Glasplatte) versehen. Diese Folie beziehungsweise Schicht hat die Aufgabe, die Wafervorderseite und somit die aufgebrachten elektrischen und mechanischen Strukturen während des anschließend folgenden Abdünnens des Wafers (durch Grinden, Läppen, Schleifen, Ätzen usw. der Rückseite) zu schützen.

Nach Aufbringen der Folie oder Schicht wird der Wafer auf der rückwärtigen Seite abgedünnt. Dadurch wird die ursprüngliche Dicke des Wafers reduziert. Die verbleibende Restdicke wird nachhaltig von den zu erwartenden mechanischen Belastungen bei den nachfolgenden Prozessschritten bestimmt, die ohne sighifikante Erhöhung der Bruchgefahr oder der Gefahr einer anderweitigen mechanischen Schädigung überstanden werden müssen. Nach dem Abdünnen kann sich zur Verbesserung der Brucheigenschaften des Wafers eine mechanische und/oder chemische Behandlung der Waferrückseite anschließen. Nach eventuellen Reinigungsschritten werden die Schutzfolie oder die Trägerschicht von der Wafervorderseite abgezogen beziehungsweise entfernt. Es können sich nun eventuelle weitere Fertigungsschritte und/oder Maßnahmen zur Verbesserung der mechanischen Eigenschaften und/oder Untersuchungen anschließen. Vielfach wird nun die Rückseite des gedünnten Wafers mit einer metallischen Schicht und/oder Schichten anderer Art überzogen und/oder strukturiert. Diese Beschichtung erfolgt meist mittels Sputtern, ähnlichen Abscheideverfahren im Vakuum und/oder lithografischen Verfahren und bedingt vielfach eine thermische Belastung und/oder thermische Unterstützung. Im Anschluss an die Rückseitenprozesse (Rückseitenbeschichtung und/oder Rückseitenstrukturierung) wird die vorderseitig schützende Folie oder der aufgebrachte Schichtverbund entfernt. Daran anschließend wird der Wafer vielfach mit der Rückseite nach unten (aktive Vorderseite nach oben) auf eine Sägefolie (Expansionsfolie beziehungsweise Rahmen) aufgelegt. Abschließend erfolgt das Sägen des Wafers (Vereinzeln des Wafers zu separaten Bauteilen) mittels Rotationstrennscheiben oder anderer mechanischer Sägevorrichtungen. Vereinzelt kommen hierbei auch bereits Lasertrennverfahren zur Anwendung. Vereinzelt werden Wafer hierbei auch gebrochen, wobei vereinzelt unterstützende Verfahren des Ritzens zur Anwendung gelangen, oder der Wafer wird mittels Ätzverfahren vereinzelt. Mit den herkömmlichen Verfahren ist es sehr schwierig, dünne Wafer ohne erhöhte Bruchgefahr oder anderweitige Beschädigungen zu behandeln beziehungsweise zu transportieren. Diese Schwierigkeiten ergeben sich unter anderem aus dem Umstand, dass der Wafer nach dem Abdünnen in Relation zu seiner geringen Dicke zu hohen mechanischen Belastungen ausgesetzt werden muss.

Folgende Belastungen treten unter anderem auf
a) während des Abziehens oder Ablösens (Enthaften) der Schutzfolie beziehungsweise Schutzschicht, die während des Abdünnens die Wafervorderseite schützt,
b) während des Auflegens des Wafers auf die Sägefolie,
c) während des Transportes zwischen dem Abdünnen und dem Vereinzeln des Wafers (Trennen in Teile des Wafers, also in dies beziehungsweise Mikroplättchen) und aller eventuell dazwischen geschalteten Fertigungsschritte. Insbesondere aber bei der Behandlung oder Beschichtung der Rückseite.

Alternativ zu den aufgezeigten Verfahren werden heute schon Verfahren zur Anwendung gebracht und/oder entwickelt, bei denen der Wafer auf der Vorderseite (der strukturierten Seite) bereits vor dem Dünnungprozess mittels Schleifen von Ritzstrukturen und/oder Ritzen und/oder chemischen Ätzen und/ oder Plasmaätzen von Strukturen (dieser Begriff schließt insoweit auch Gräben ein) so strukturiert wird, dass diese Strukturen während des sich anschließenden Dünnungsprozesses mittels mechanischer und oder chemischer Verfahren freigelegt werden und somit eine Vereinzelung des Wafers stattfindet (Dicing before Grinding). Hierbei ist aber sehr oft nachteilig, dass die nunmehr vereinzelten Teile des Wafers (dies) nicht mehr wirtschaftlich während der nachfolgenden Prozessschritte gehandhabt werden können. Dieses begründet sich in der Tatsache, dass hierbei die Vielzahl bereits vereinzelter Bauelemente so fixiert sein muss, dass sich diese während der zu durchlaufenden Fertigungsschritte nicht ablösen und/oder ihre Position verändern.

Stand der Technik für die Befestigung des Wafers für das Dünnen sind so genannte "Grinding Tapes", die zum Beispiel von der Firma Nitto erhältlich sind (siehe z.B. EP 0 977 254 A2). Für diesen Anwendungszweck werden Haftklebemassen verwendet, die aus einem mehr oder weniger haftklebenden Basispolymer aus Poly(meth)acrylaten bestehen, dem Oligomere und/oder Monomere mit polymerisierbaren Doppelbindungen und UV-strahlungsaktive Photoinitiatoren zugemischt werden. Die Haftung des Klebebands am Wafer wird hier durch UV-Strahlung vermindert, so dass das Klebeband wieder vom Wafer entfernt werden kann.

In der EP 0 194 706 A1 wird ein haftklebendes Compound beschrieben, das aus einem elastischen mit Polyisocyanaten vernetzten Poly(meth)acrylat besteht, dem mehrfach ungesättigte Acrylat-Monomere beziehungsweise -Oligomere, Photoinitiatoren sowie harzartige Klebrigmacher und/oder Silicagel zugemischt werden.

Die EP 0 298 448 A1 nennt über Polyisocyanate vernetzte Polyacrylhaftkleber, die mit mehrfach acrylierten Cyanuraten oder Isocyanuraten und Photoinitiatoren gemischt werden.

Die EP 0 622 833 A1 beansprucht eine Haftklebemasse, die aus einem OH-Gruppen enthaltenden und mit Diisocyanaten vernetzten Polyacrylat sowie einem Urethanoligomer vom Molgewicht von ungefähr 6000 mit mindestens zwei Acryldoppelbindungen und Photoinitiatoren hergestellt wird.

Eine ähnlich hergestellte Haftklebemasse wird in der DE 36 39 266 A1 beschrieben. In der JP 06 049 420 A wird eine Haftklebemasse beansprucht, die aus einem Basispolymer, polyfunktionellen Urethanen mit Molgewichten von 15 000 bis 50 000 g/mol, Weichmachern und Photoinitiatoren gemischt wird.

Abweichend von dem oben allgemein beschriebenen Verfahren nennt die EP 0 588 180 A1 eine nicht compoundierte Haftklebemasse, die einen Photoinitiator einpolymerisiert enthält und bei UV-Bestrahlung an Klebkraft verliert. Ein Hauptbestandteil dieses Acrylcopolymers sind unter anderem Acrylatester-Einheiten mit Alkylgruppen </= C14.

Auch aus der EP 0 252 739 A2 und der DE 195 20 238 C2 sind Klebebänder zum Halten von Wafern bekannt.

Mit den gegenwärtig üblichen Lösungen für Grinding Tapes ist es sehr schwierig und teilweise unmöglich, Wafer auf sehr geringe Dicken herunterzudünnen, da die verwendeten Haftklebemassen keinen genügenden Kontakt z. strukturierten Oberfläche des Wafers aufbauen. Die gedünnten Wafer oder die bereits vereinzelten Teile des zuvor gedünnten Wafers (dies) können auf der Waferrückseite aufgrund der mangelnden Temperaturbeständigkeit auch nicht wirtschaftlich beschichtet werden.

Insoweit dieses gegenwärtig geschieht, treten große Fertigungsverluste durch Waferbruch und/oder anderweitige Beschädigungen auf und/oder sind zu deren Vermeidung erhebliche manuelle Maßnahmen notwendig. Hierbei müssen zurzeit die Wafer und/oder die vereinzelten Waferteile meistens sehr aufwändig und/oder sehr vorsichtig von Menschenhand und/oder durch aufwendige Vorrichtungen behandelt werden. Die Schwierigkeit ist hierbei insbesondere in der extrem dünnen Materialstärke des Wafers und/oder der Vielzahl der eventuell bereits vereinzelten Waferteile begründet.

Es gibt bislang auch keine in industriellem Maßstab verwirklichte und zufrieden stellende Lösung, um einen stark gedünnten Wafer mit einer Rückseitenmetallisierung versehen zu können, da alle Formen von bislang bekannten Trägerfolien aufgrund der benötigten hohen Metallisierungstemperatur versagen.

Als zu beschichtende Oberflächen kommen aus heutiger Sicht hauptsächlich Waferoberflächen zum Einsatz, die mit einer Schutzschicht aus Siliziumnitrid und/oder Siliziumoxid beziehungsweise Polyimid versehen sind. Grundsätzlich sind aber auch andere Werkstoffe nicht ausgeschlossen. Außerdem sind die Oberflächen in der Regel durch elektrische Schaltungen oder zusätzlich durch ein "Dicing"-Verfahren strukturiert, durch welches die Wafer für die Trennung in einzelne Dies vorbereitet wurden.

Aus dem Stand der Technik sind Verfahren zur Bearbeitung eines Wafers bekannt, bei denen insbesondere die Wafervorderseite zeitweise zum Schutz und/oder zum vereinfachten Handling abgedeckt wird. So offenbart die DE 100 29 035 C1 ein Verfahren zur Bearbeitung eines Wafers, bei dem ein so genannten Trägerwafer auf den zu bearbeitenden Wafer aufgebracht wird. Die beiden Wafer werden mittels einer Verbindungsschicht verbunden, die teilweise in Löcher des Trägerwafers eingebracht wird und so auf den durch die Löcher freiliegenden Teilen des zu bearbeitenden Wafers aufliegt. Nach Durchführen von Bearbeitungsschritten an der Rückseite des zu bearbeitenden Wafers wird der Trägerwafer durch Entfernen der Verbindungsschicht wieder abgetrennt.

Die US 5,981,391 A offenbart ein Verfahren zur Herstellung einer Halbleitervorrichtung, das das Schützen der Vorderseite eines Wafers durch ein adhäsives Medium umfasst sowie das Entfernen dieses adhäsiven Mediums nach Bearbeiten der Rückseite des Wafers und das Erwärmen des Wafers nach dem Entfernen des adhäsiven Mediums auf eine Temperatur, die höher ist als die thermische Zersetzungstemperatur des Adhäsivs, das durch das adhäsive Medium zur Verfügung gestellt wurde.

Die WO 99/08322 A1 offenbart einen beschichteten Wafer, wobei die Beschichtung immer zumindest Titan umfasst.

Die WO 99/48137 A1 offenbart ebenfalls einen mit einer Schicht versehenen Wafer, bei dem die Schicht die Vorderseite des Wafers bei nachfolgenden Bearbeitungsschritten schützen soll. Ein solcher Gegenstand wird auch in der DE 198 11 115 A1 offenbart, wobei in beiden Dokumenten die Schicht zumindest bis nach dem Vereinzeln des Wafers in Dies auf dem Wafer verbleibt.

Die US 6,263,566 B1 offenbart ebenfalls einen Wafer mit einer Beschichtung, von der ausgewählte Bereiche nach Bearbeitungsschritten wieder entfernt werden können.

Die Firmenschrift "Wafer Support System" der 3M (St. Paul, MN, USA, Nr. 4834 (HB) 60 5002 0049-2) offenbart ebenfalls ein Verfahren zum Fixieren eines Wafers für das Dünnen, bei dem der Wafer mittels einer "Light-to Heat-Conversion (LTHC)"-Layer und einem UV-härtbaren Flüssigkleber auf einer sehr ebenen Glasplatte fixiert wird. Durch Bestrahlung der LTHC-Layer mit einem Laser kann die Glasplatte abgelöst werden, sodann kann der ausgehärtete Flüssigkleber von der Waferoberfläche abzogen werden.

WO 2004/051708 A2 offenbart ein Verfahren zum Bearbeiten eines Wafers, der auf einer Seite (Vorderseite) Bauelemente trägt, mit folgenden Schritten: Applizieren eines Schichtsystems auf der Vorderseite des Wafers, wobei das Schichtsystem zumindest eine die Vorderseite des Wafers kontaktierende Trennschicht und eine Trägerschicht umfasst, Abdünnen der Rückseite des Wafers, so dass das Schichtsystem den Wafer oder Teile des Wafers während des Abdünnens schützt oder trägt (hält). Dabei ist die Trennschicht eine plasmapolymere Schicht, die an dem Wafer haftet und an der Trägerschicht fester haftet als an dem Wafer. Dabei werden die Verfahren PECVD beziehungsweise Plasmapolymerisation für die Trennschicht und Spin-Coating für den Auftrag der Trägerschicht angewendet, die in der Halbleiterindustrie üblich sind. Als Trägerschicht werden Polyamid- beziehungsweise Polyamid-Precursor oder Flüssigsilikon vorgeschlagen, welches nach dem Auftragen ausgehärtet wird und als Schicht wieder entfernt werden kann. Nachteilig ist die mangelnde Schichtdicke, die durch Spin-Coating erzielt werden kann, so dass der Prozess mehrfach wiederholt werden muss; um eine für die mechanische Stabilität beim Abziehen des Schichtverbunds notwendige Schichtdicke zu erreichen. Die Ebenheit einer solchen mehrfach aufgebrachten Schicht wäre darüber hinaus für eine Bezugsfläche für das Dünnen nicht ausreichend. Das ebenfalls vorgeschlagene Aufbringen einer Stützfolie würde einen weiteren Arbeitsgang erfordern.

Eine weitere Herausforderung, die nach dem Stand der Technik noch nicht zufrieden stellend gelöst ist, ist die Fixierung gebumpter Wafer. Insbesondere derzeitige Grinding-Tapes eignen sich dafür nicht, da die verwendeten Haftklebemassen aufgrund der herausstehenden Bumps (Lotkugeln) nur unzureichend die Oberfläche benetzen. Auch die verwendete Technologie zum Abschalten der Hafteigenschaften der Tapes für die Trennung vom Wafer (Aushärtung der Klebemasse durch UV-Strahlung oder thermisch initiierte Prozesse) sind für gebumpte Wafer weniger geeignet, da hierbei die Haftklebemasse auch in den Hinterschnitten an den Bumps aushärtet und somit das Abtrennen nicht gelingt oder die Bumps beschädigt werden.

Die im Stand der Technik offenbarten Beschichtungen sind allesamt noch nicht optimal und lassen sich zum Beispiel nur teilweise oder unter hohem Aufwand wieder vom Wafer trennen. Darüber hinaus ist das Aufbringen der Schichten häufig umständlich, muss in mehreren Arbeitsgängen erfolgen, und das Schichtmaterial ist nicht optimal an seine Aufgaben angepasst.

Aufgabe der Erfindung ist es daher, ein Verfahren zum Bearbeiten eines Wafers zur Verfügung zu stellen, mit dem die sichere Fixierung eines Schichtmaterials an stark strukturierten Oberflächen, insbesondere von gebumpten Wafern, gelingt, wobei bevorzugt das Schichtmaterial von der Oberfläche wieder abtrennbar ist. Weiter bevorzugt soll eine hohe thermische Stabilität sowohl in mechanischer als auch in chemischer Hinsicht erreicht werden, die zum Beispiel eine Rückseitenbeschichtung von Wafern ermöglicht.

Gelöst wird diese Aufgabe durch ein Verfahren, wie es im Hauptanspruch niedergelegt ist. Gegenstand der Unteransprüche sind dabei vorteilhafte Weiterbildungen des Verfahrens.

Demgemäß betrifft die Erfindung ein Verfahren zum Bearbeiten eines Wafers, der bevorzugt auf einer Seite (Vorderseite) Bauelemente trägt, gekennzeichnet durch die folgenden Schritte:
- Applizieren eines polymeren Schichtmaterials auf die Vorderseite, wobei das polymere Schichtmaterial zumindest eine viskoelastische Schicht mit folgenden Eigenschaften umfasst
   ■ das Erreichen einer Schubspannung von zumindest 1000 Pa im Schubspannungszeitrampentest bei einer Temperatur von 20 °C und einer Schubspannungsrampe von 100 Pa/min, ohne dass das viskoelastische Material anfängt zu fließen,
   ■ eine komplexe Viskosität eta* von weniger als 50000 Pas im oszillatorischen Scherexperiment (DMA) bei der Applikationstemperatur und einer Frequenz von 0.01 s⁻¹,
   ■ die Fähigkeit zur Erhöhung der Kohäsion und damit Absenkung der Fließfähigkeit durch Vernetzung der Schicht,
   ■ die zumindest teilweise Gummielastizität der viskoelastischen Schicht nach der Vernetzung zur rückstandfreien späteren Abtrennung von der Oberfläche nach der Vernetzung, gekennzeichnet durch einen tan delta im oszillatorischen Scherexperiment bei der Trenntemperatur und einer Frequenz von 100 s⁻¹ unterhalb von 1,
- Herabsetzen der Viskosität der zumindest einen viskoelastischen Schicht im Schichtverbund durch Einbringen von Energie, so dass ein Auffließen auf die Wafervorderseite und somit eine zumindest teilweise stoffschlüssige Verbindung damit stattfindet
- Vernetzen der zumindest einen viskoelastischen Schicht, so dass eine Schicht mit zumindest teilweise gummielastischem Charakter entsteht, die die raue Oberfläche zumindest teilweise benetzt
- Abdünnen und/oder Beschichten und/oder Behandeln der Waferrückseite
- Ablösen der viskoelastischen Schicht nach der Bearbeitung des Wafers

Unter rauer (oder im Folgende auch als strukturierte Oberfläche bezeichnet) Oberfläche wird dabei eine Oberfläche mit einer Rautiefe Rₘₐₓ nach DIN 4768 von zumindest 10 µm verstanden.

Der Schubspannungszeitrampentest (Stress Ramp Test) dient der Ermittlung einer eventuell vorhandenen Fließgrenze bzw. dem Nachweis, dass das Material nicht fließfähig ist. Dabei wird eine Probe mit einer Schubspannung beaufschlagt, die kontinuierlich mit der Zeit ansteigt. Die Schubspannung, bei der die Probe anfängt zu fließen, wird als Fließgrenze (Yield Point, Yield Stress) bezeichnet. Der Test ist ausführlich in Rüdiger Brummer "Rheology Essentials of Cosmetic and Food Emulsions", Springer, 2005, Seite 65 bis 67 beschrieben.

Das Erreichen einer Schubspannung von zumindest 1000 Pa im Schubspannungszeitrampentest bei einer Temperatur von 20 °C, ohne dass das viskoelastische Material anfängt zu fließen, kennzeichnet einen geringen oder gar keinen kalten Fluss des viskoelastischen Schicht. Unter kaltem Fluss wird dabei das Fließen der viskoelastischen Schicht unter Einfluss der Schwerkraft oder einer anderen geringen, permanent während der Lagerung wirkenden Kraft, wie zum Beispiel dem Wickeldruck in einer Rolle aus dem erfindungsgemäßen Schichtmaterial, verstanden. Der kalte Fluss ist bevorzugt so gering, dass das Schichtmaterial bei Raumtemperatur zumindest sechs Monate in mehreren Lagen (als Blattware oder auf Rolle) gelagert werden kann, ohne dass die viskoelastische Schichten der jeweiligen Lagen miteinander in Kontakt kommen und die Lagen somit miteinander verkleben.

Das Erreichen einer Schubspannung von zumindest 1000 Pa im Schubspannungszeitrampentest bei einer Temperatur von 20 °C, ohne dass das viskoelastische Material anfängt zu fließen, wird durch thixotropes rheologisches Verhalten oder eine ausgeprägte (scheinbare) Fließgrenze des viskoelastischen Materials erreicht. Diese rheologischen Eigenschaften sind in Pahl et al. "Praktische Rheologie der Kunststoffe und Elastomere", VDI-Verlag, 1995, Seite 53 bis 55 und Seite 385 bis 389 ausführlich definiert. Alternativ wird diese Eigenschaft dadurch erreicht, dass die zumindest eine Schicht während der Lagerung zumindest teilweise als Festkörper, wie zum Beispiel eine Thermoplast oder Elastomer bei Raumtemperatur, vorliegt. Thixotropes Fließverhalten oder eine Fließgrenze wird in einer bevorzugten Ausführung der Erfindung durch die Zugabe von Füllstoffen erreicht. Bevorzugt werden dabei Füllstoffe, die aufgrund von Teilchenwechselwirkungen in der Lage sind, ein Füllstoffnetzwerk auszubilden. Geeignet sind hier zum Beispiel pyrogene Kieselsäuren, Schichtsilikate, Nanotubes oder Ruße.

Weiterhin wird oben genanntes Fließverhalten bevorzugt durch die Ausbildung eines Gelnetzwerks innerhalb des Polymeren erreicht.

Im technischen Sinne werden unter Gelen verstanden relativ formbeständige, leicht verformbare disperse Systeme aus zumindest zwei Komponenten, welche in der Regel aus einem kolloid zerteilten Stoff aus langkettigen Molekülgruppierungen (zum Beispiel Gelatine, Polysaccharide, Cellulose und deren Derivate, Blockcopolymere) als Gerüstbildner und einem flüssigen Dispersionsmittel (hier zum Beispiel einem fließfähigen Polymer) bestehen. Der kolloidal zerteilte Stoff wird oft als Verdickungs- oder Geliermittel bezeichnet. Er bildet ein räumliches Netzwerk im Dispersionsmittel, wobei einzelne kolloidal vorliegende Partikel über Wechselwirkungen miteinander mehr oder weniger fest verknüpft sein können. Das Dispersionsmittel, welches das Netzwerk umgibt, zeichnet sich durch Affinität zum Geliermittel aus, das heißt, ein vorwiegend polares Geliermittel geliert vorzugsweise ein polares Dispersionsmittel, wohingegen ein vorwiegend unpolares Geliermittel vorzugsweise unpolare Dispersionsmittel geliert.

Starke elektrostatische Wechselwirkungen, welche beispielsweise in Wasserstoffbrückenbindungen zwischen Geliermittel und Dispersionsmittel, aber auch zwischen Dispersionsmittelmolekülen untereinander verwirklicht sind, können zu starker Vernetzung auch des Dispersionsmittels führen. Hydrogele können zum Beispiel zu fast 100% aus Wasser bestehen (neben beispielsweise ca. 0,2 bis 1,0 % eines Geliermittels) und dabei durchaus feste Konsistenz besitzen. Der Wasseranteil liegt dabei in eisähnlichen Strukturelementen vor.

Die komplexe Viskosität eta* von weniger als 50000 Pas im oszillatorischen Scherexperiment bei einer Applikationstemperatur und einer Frequenz von 0.01 s⁻¹ bedeutet eine geringe Viskosität während der Applikation auf die strukturierte Oberfläche. Haftklebemassen üblicher Grinding Tapes zeigen hier typischerweise Werte von mehr als 100000 Pas. Das oszillatorische Scherexperiment wird in Pahl et al. "Praktische Rheologie der Kunststoffe und Elastomere", VDI-Verlag, 1995, Seite 119 bis 150, ausführlich definiert. Die hier angegebenen Werte gelten bei Verwendung einer Platte-Platte-Konfiguration bei einem Plattendurchmesser von 25 mm.

Die geringe Viskosität während der Applikation wird durch Erhöhung der Temperatur und/oder dem Aufbringen von Scher- und/oder Dehnkräften erreicht. Die Temperaturerhöhung bewirkt dabei ein Erweichen des Schichtmaterials, so dass es fließfähiger wird. Scher- und/oder Dehnkräfte führen bei strukturviskosen Materialien ebenfalls zu einer Erniedrigung der Viskosität und somit zum verbesserten Einfließen in die strukturierte Oberfläche. Diese Eigenschaft ist prinzipiell mit allen dem Fachmann bekannten Polymeren erreichbar, die strukturviskoses Fließverhalten aufweisen und/oder schmelzbar sind. Zusätzlich führen Scher- und/oder Dehnkräften bei entsprechenden Materialien zur Auflösung des Füllstoffnetzwerks oder Gels und somit zur Erniedrigung der Viskosität. Das Auffließen auf die strukturierte Oberfläche des Wafers wird bevorzugt durch Andrücken unterstützt.

Die Temperaturerhöhung kann dabei durch jedes dem Fachmann bekannte Verfahren erreicht werden. Dies umfasst Wärmeleitung durch Heizplatten, Konvektion durch temperierte Gase oder Flüssigkeiten, Einsatz von elektromagnetischen Wellen (zum Beispiel Infrarot, Mikrowellen, magnetische oder elektrische Wechselfelder) sowie chemische oder physikalische Umwandlungen, wobei diese Aufzählung nicht genannte Verfahren nicht ausschließen soll.

Scher- und/oder Dehnkräfte werden bereits durch das Andrücken des Schichtmaterials an die strukturierte Oberfläche des Wafers aufgebracht. Hoher Druck erhöht diese Kräfte. Ein strukturviskoses rheologisches Verhalten des Schichtmaterials führt zu einer Verringerung der Viskosität. Strukturviskoses Verhalten ist ebenfalls bei Pahl (siehe oben) definiert. Die Scher- und/oder Dehnkräfte können durch das Aufbringen von Schubkräften auf das Schichtmaterial noch verstärkt werden. Andruck- oder Schubkräfte können vorteilhaft auch oszillierend aufgebracht werden, so dass die mechanischen Wege während der Applikation gering gehalten werden können bzw. bei vorgegebenem mechanischem Weg die Dauer der Einwirkung erhöht werde kann.

Zur Erhöhung der Kohäsion werden die für die erfinderischen Schichtmaterialien eingesetzten viskoelastischen Materialien nach dem Auffließen auf die strukturierte Oberfläche vernetzt, wobei hohe Vernetzungsgrade angestrebt werden, um eine hohe Temperaturstabilität zu erreichen. Nach einer bevorzugten Ausgestaltung der Erfindung weist das mindestens eine viskoelastische Material einen Vernetzungsgrad auf, der mindestens einem Gelwert von 50 %, insbesondere von mindestens 75 % entspricht. Dabei wird als Gelwert das Verhältnis von nicht in einem geeigneten Lösemittel löslicher Komponente zu löslicher Komponente definiert.

In einer bevorzugten Vorgehensweise werden die Haftklebemassen mit UV- oder Elektronenstrahlen vernetzt. Eine ausführliche Beschreibung des Standes der Technik und die wichtigsten Verfahrensparameter findet man in "Chemistry and Technology of UV and EB formulation for Coatings, Inks and Paints", Vol. 1, 1991, SITA, London. Es können auch andere Verfahren eingesetzt werden, die hochenergetische Bestrahlung ermöglichen.

Zur Verringerung der erforderlichen Strahlendosis können dem viskoelastischen Material Vernetzer und/oder Promotoren zur Vernetzung beigemischt werden, insbesondere durch UV-, Elektronenstrahlen oder thermisch anregbare Vernetzer und/oder Promotoren. Geeignete Vernetzer für die Strahlvernetzung sind bi- oder multifunktionelle Acrylate oder Methacrylate. In einer weiteren bevorzugten Auslegung werden die Haftklebemassen mit thermisch aktivierbaren Vernetzern vernetzt. Hierzu werden bevorzugt Peroxide, Metallchelate, bi- oder multifunktionelle Epoxide, bi- oder multifunktionelle Hydroxide sowie bi- oder multifunktionelle Isocyanate beigemischt.

Der gummielastische Zustand ist in Ferry "Viscoelastic Properties of Polymers" (3rd edition, John Wily & Sons, New York, 1980), Seite 233 bis 240, definiert. Erfindungsgemäß ist auch, wenn geringe Fließfähigkeit des Materials weiterhin gegeben ist, der gummielastische Zustand also nicht ideal erreicht wird. Zumindest liegt jedoch der tan delta im oszillatorischen Scherexperiment bei einer Trenntemperatur und einer Frequenz von 100 s⁻¹ unterhalb von 1. Die hohe Elastizität der Schicht wird zum Beispiel dadurch erreicht, dass die Glasübergangstemperatur des verwendeten viskoelastischen Materials nach der Vernetzung unterhalb der Temperatur liegt, bei der das Schichtmaterial von der strukturierten Oberfläche getrennt wird. Bevorzugt liegt die Glasübergangstemperatur unterhalb der Raumtemperatur. Durch die hohe Elastizität wird ein leichtes und beschädigungsfreies Entfernen von der Oberfläche, insbesondere bei Strukturierungen mit Hinterschneidungen, wie zum Beispiel gebumpte Wafer, ermöglicht. Die durch Vernetzung erhöhte Kohäsion trägt dabei zur Vermeidung von Rückständen bei.

In einer bevorzugten Ausführung der Erfindung besitzt die viskoelastische Schicht eine Dicke von mehr als 100 µm, besonders bevorzugt mehr als 200 µm. Damit wird die komplette Umhüllung auch von größeren Bumps gewährleistet.

In einer vorteilhaften Ausführung der Erfindung ist die zumindest eine viskoelastische Schicht über zumindest eine Stunde beständig gegen eine Temperatur von mehr als 200 °C, bevorzugt mehr als 300 °C, um so zum Beispiel eine Behandlung der Rückseite eines Wafers zu ermöglichen. Die Temperaturbeständigkeit wird mittels Thermogravimetrischer Analyse bestimmt. Die Probe wird dabei unter Inertgasatmosphäre mit einer Rate von 10 °C/min aufgeheizt und gleichzeitig gewogen. Der Gewichtsverlust wird über der Temperatur aufgetragen. Gewichtsverlust unterhalb von 150 °C wird in der Regel dem Ausgasen von Wasser, Restlösemitteln oder Restmonomeren zugeordnet, Gewichtsverlust oberhalb von 150 °C in der Regel einem thermischen Abbau der Probe.

Bevorzugt werden daher hochtemperaturbeständige Polymere wie zum Beispiel Silikone, Acrylate oder Synthesekautschuke eingesetzt, ohne durch diese Auflistung die Auswahl einschränken zu wollen. In einer bevorzugten Variante ist die viskoelastische Schicht haftklebrig, da hierdurch die Applikation auf die raue Oberfläche erleichtert wird.

Als mögliche Siliconmassen können zum Beispiel DC 280, DC 282, Q2-7735, DC 7358, Q2-7406 von Dow Corning, PSA 750, PSA 518, PSA 6574 von GE Bayer Silicones, KRT 001, KRT 002, KRT 003 von ShinEtsu und Siliconkautschuke aus der Elastosil-, der Powersil-Serie sowie PSA 45559 von Wacker Silicones eingesetzt werden, ohne durch diese Nennungen die Auswahl einschränken zu wollen.

Erfindungsgemäß vorteilhaft lassen sich als viskoelastische Schicht Haftklebemassen auf Basis von Acrylsäure und/oder Methacrylsäure und/oder auf Basis von Estern der vorgenannten Verbindungen einsetzen. Es sind insbesondere Acrylathaftklebemassen als Klebstoffkomponente geeignet, welche etwa durch radikalische Polymerisation erhältlich sind und die zumindest teilweise auf mindestens einem Acrylmonomer der allgemeinen Formel (1) basieren, 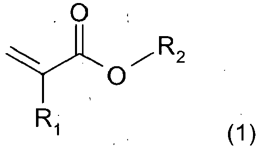 wobei R1 gleich H oder ein CH3-Rest ist und R2 gleich H ist oder aus der Gruppe der gesättigten, unverzweigten oder verzweigten, substituierten oder nicht-substituierten C1-bis C30-Alkylresten gewählt ist. Das mindestens eine Acrylmonomer sollte einen Massenanteil von mindestens 50 % in der Haftklebemasse aufweisen.

Es lassen sich nach einer besonders vorteilhaften Ausgestaltung Polymere als Klebstoffkomponente einsetzen, die
(a1) zumindest teilweise auf mindestens einem Acrylmonomer der allgemeinen Formel CH2=C(R1)(COOR2) basieren, wobei R1 gleich H oder ein CH3-Rest ist und R2 aus der Gruppe der gesättigten, unverzweigten oder verzweigten, substituierten oder nicht-substituierten C2- bis C20-Alkylresten gewählt ist, und
(a2) zumindest teilweise auf einen mit dem mindestens einen Acrylmonomer polymerisierbaren Comonomer basieren, welches insbesondere aus Vinylverbindungen mit funktionellen Gruppen, Maleinsäureanhydrid, Styrol, Styrol-Verbindungen, Vinylacetat, Acrylamiden, mit Doppelbindung funktionalisierten Photoinitiatoren gewählt werden kann.

Dabei weist vorzugsweise das mindestens eine Acrylmonomer (a1) einen Massenanteil von 65 bis 100 Gew.-% und das mindestens eine Comonomer (a2) einen Massenanteil von 0 bis 35 Gew.-% in der Klebstoffkomponente auf.

In einer sehr bevorzugten Weise werden Acryl- oder Methacrylmonomere der allgemeinen Formel (1) eingesetzt, die Acryl- und Methacrylsäureester umfassen, wobei die Gruppe R2 aus der Gruppe der gesättigten, unverzweigten oder verzweigten, substituierten oder nicht-substituierten C4- bis C14-Alkylresten, insbesondere C4- bis C9-Alkylresten, gewählt ist. Spezifische Beispiele, ohne sich durch diese Aufzählung einschränken zu wollen, sind Methylacrylat, Methylmethacrylat, Ethylacrylat, n-Butylacrylat, n-Butylmethacrylat, n-Pentylacrylat, n-Hexylacrylat, n-Heptylacrylat, n-Octylacrylat, n-Octylmethacrylat, n-Nonylacrylat, Laurylacrylat, Stearylacrylat, Behenylacrylat, und deren verzweigten Isomere, beispielsweise Isobutylacrylat, 2-Ethylhexylacrylat, 2-Ethylhexylmethacrylat, Isooctylacrylat, Isooctylmethacrylat.

Weitere einzusetzende Verbindungsklassen sind monofunktionelle Acrylate beziehungsweise Methacrylate der allgemeinen Formel (1), wobei der Rest R2 aus der Gruppe der überbrückten oder nicht-überbrückten Cycloalkylresten mit mindestens 6 C-Atomen gewählt ist. Die Cycloalkylreste können auch substituiert sein, beispielsweise durch C1- bis C6-Alkylgruppen, Halogenatomen oder Cyanogruppen. Spezifische Beispiele sind Cyclohexylmethacrylat, Isobornylacrylat, Isobornylmethacrylat und 3,5-Dimethyladamantylacrylat.

In einer bevorzugten Vorgehensweise werden Acrylmonomere und/oder Comonomere eingesetzt, die einen oder mehrere, insbesondere polare Substituenten aufweisen, beispielsweise Carboxyl-, Sulfonsäure-, Phosphonsäure-, Hydroxyl-, Lactam-, Lacton-, N-substituierte Amid-, N-substituierte Amin-, Carbämat-, Epoxy-, Thiol-, Alkoxy-, Cyan-, Halogenid- und Ethergruppen.

Sehr vorteilhaft im Sinne der Acrylkomponente (a1) eignen sich Monomere, welche aus der folgenden Gruppe ausgewählt sind:
substituierte oder nicht-substituierte Verbindungen, umfassend Methylacrylat, Methylmethacrylat, Ethylacrylat, n-Butylacrylat, n-Butylmethacrylat, n-Pentylacrylat, n-Hexylacrylat, n-Heptylacrylat, n-Octylacrylat, n-Octylmethacrylat, n-Nonylacrylat, Laurylacrylat, Stearylacrylat, Behenylacrylat, Isobutylacrylat, 2-Ethylhexylacrylat, 2-Ethylhexylmethacrylat, Isooctylacrylat, Isooctylmethacrylat, Cyclohexylmethacrylat, Isobornylacrylat, Isobornylmethacrylat und 3,5-Dimethyladamantylacrylat.

Es sind ebenfalls moderat basische Comonomere (a2) geeignet, wie einfach oder zweifach N-alkylsubstituierte Amide, insbesondere Acrylamide. Spezifische Beispiele sind hier N,N-Dimethylacrylamid, N,N-Dimethylmethacrylamid, N-tert-Butylacrylamid, N-Vinylpyrrolidon, N-Vinyllactam, Dimethylaminoethylacrylat, Dimethylaminoethylmethacrylat, Diethylaminoethylacrylat, Diethylaminoethylmethacrylat, N-Methylolacrylamid, N-Methylolmethacrylamid, N (Butoxymethyl)methacrylamid, N-(Ethoxymethyl)acrylamid, N Isopropylacrylamid, wobei diese Aufzählung nicht abschließend ist.

Weitere bevorzugte Beispiele für Comonomere (a2) sind aufgrund der für eine Vernetzung nutzbaren funktionellen Gruppen Hydroxyethylacrylat, Hydroxyethylmethacrylat, Hydroxypropylacrylat, Hydroxypropylmethacrylat, Allylalkohol, Maleinsäureanhydrid, Itaconsäureanhydrid, Itaconsäure, Glyceridylmethacrylat, Phenoxyethylacrylat, Phenoxyethylmethacrylat, 2-Butoxyethylacrylat, 2-Butoxyethylmethacrylat, Cyanoethylacrylat, Cyanoethylmethacrylat, Glycerylmethacrylat, 6-Hydroxyhexylmethacrylat, Vinylessigsäüre, Tetrahydrofurfurylacrylat, β-Acryloyloxypropionsäure, Trichloracrylsäure, Fumarsäure, Crotonsäure, Aconitsäure, Dimethylacrylsäure, wobei diese Aufzählung nicht abschließend ist.

In einer weiteren sehr bevorzugten Vorgehensweise werden als Comonomere (a2) Vinylverbindungen, insbesondere Vinylester, Vinylether, Vinylhalogenide, Vinylidenhalogenide, Vinylverbindungen mit aromatischen Cyclen und Heterocyclen in α-Stellung eingesetzt. Auch hier seien nicht ausschließlich einige Beispiele genannt, wie Vinylacetat, Vinylformamid, Vinylpyridin, Ethylvinylether, Vinylchlorid, Vinylidenchlorid, Styrol und Acrylonitril.

Besonders vorteilhaft kann das mindestens eine Comonomer (a2) ein Photoinitiator mit einer copolymerisierbaren Doppelbindung sein, insbesondere ausgewählt aus der Gruppe enthaltend Norrish-I- oder Norrish-II-Photoinitiatoren, Benzoinacrylate oder acrylierte Benzophenone.

In einer weiteren bevorzugten Vorgehensweise werden zu den beschriebenen Comonomeren (a2) Monomere hinzugesetzt, die eine hohe statische Glasübergangstemperatur besitzen. Als Komponenten eigenen sich aromatische Vinylverbindungen, wie zum Beispiel Styrol, wobei bevorzugt die aromatischen Kerne aus C4- bis G18-Bausteinen bestehen und auch Heteroatome enthalten können. Besonders bevorzugte Beispiele sind 4-Vinylpyridin, N-Vinylphthalimid, Methylstyrol, 3,4-Dimethoxystyrol, 4-Vinylbenzoesäure, Benzylacrylat, Benzylmethacrylat, Phenylacrylat, Phenylmethacrylat, t-Butylphenylacrylat, t-Butylphenylmethacrylat, 4-Biphenylacrylat und -methacrylat, 2-Naphthylacrylat und -methacrylat sowie Mischungen aus denjenigen Monomeren; wobei diese Aufzählung nicht abschließend ist.

Ganz besonders bevorzugt werden Zusammensetzungen überwiegend bestehend ausComonomeren mit linearen Seitenketten wie zum Beispiel Methylacrylat oder Butylacrylat. Weiterhin besonders vorteilhaft für eine hohe Temperaturstabilität ist eine kovalente Vernetzung der Acrylat-Haftklebemassen.

Als temperaturbeständige Synthesekautschuke werden vorteilhaft Stryrol-BlockCopolymere mit hydrogeniertem Mittelblock wie SEPS, SEP, SEPS oder SEEPS, erhältlich zum Beispiel von der Firma Kraton (Kraton G) oder Kuraray (Septon), eingesetzt. Besonders bevorzugt werden dabei funktionalisierte Typen wie die Kraton FG-Serie, Asahi Tuftec™ M 1913 bzw. Tuftec™ M 1943 oder Septon HG252 (SEEPS-OH). Weitere bevorzugte Blockcopolymere sind zum Beispiel unter dem Namen Epofriend™ A 1005, A 1010 oder A 1020 der Firma Daicel erhältlich Durch Zugabe geeigneter Vernetzungsagentien (zum Beispiel mehrwertige Isocyanate, Amine, Epoxide, Alkohole, Phenole, Guanidine, Mercaptane Carbonsäuren bzw. Säureanhydride) können diese vernetzt und damit thermisch stabilisiert werden. Auch eine Kombination von säure- oder säureanhydridmodifizierten Vinylaromatenblockcopolymer (zum Beispiel Kraton FG-Serie) und einem epoxidierten Vinylaromatenblockcopolymer (zum Beispiel Daicel Epofriend-Serie) ist vorteilhaft nutzbar.

In einer bevorzugten Ausführung beinhaltet das Schichtmaterial zumindest eine weitere Schicht, die die viskoelastische Schicht zumindest einseitig abdeckt und als Release-Liner dient, welcher zumindest einseitig vor der Applikation auf die strukturierte Oberfläche des Wafers entfernt wird. Insbesondere in Fall von haftklebrigen viskoelastischen Schichten ist diese Ausführung vorteilhaft.

In einer weiteren bevorzugten Ausführung des Schichtmaterials beinhaltet das Schichtmaterial eine Schicht, die als permanenter Träger der viskoelastischen Schicht dient. Dies dient der weiteren Stabilisierung der viskoelastischen Schicht während der Lagerung, der Applikation sowie dem Ablösen. Hier sind prinzipiell alle dem Fachmann bekannten Trägermaterialien, wie sie zum Beispiel im "Handbook of Pressure Sensitive Adhesive Technology" von Donatas Satas (van Nostrand, New York 1989) genannt sind, möglich. Bevorzugt werden Folien, insbesondere Metallfolien oder hochtemperaturbeständige Polymerfolien, wie zum Beispiel Polyimid, Polyamidimid, Polysulfon, Polyethersulfon, Polyetherketon, Polyehteretherketon, Polyetherimid, Polyphenylensulfid, fluorierte Polymere (PTFE etc.). Zur Verbesserung der Haftung der viskoelastischen Schicht kann dieses Trägermaterial chemisch oder physikalisch vorbehandelt sein, wobei alle dem Fachmann bekannten Methoden zum Einsatz kommen können.

In einer weiteren bevorzugten Ausführung des Schichtmaterials beinhaltet das Schichtmaterial einen Trennmechanismus zur strukturierten Oberfläche des Wafers. Dieser ist in einer vorteilhaften Ausführung in die viskoelastische Schicht integriert. Dazu enthält diese Schicht beispielsweise ein unverträgliches Polymer, welches bei einem Stimulus wie zum Beispiel einer Temperaturerhöhung, an die Grenzfläche zwischen Schichtmaterial und strukturierter Oberfläche des Wafers migriert. Ein diesbezüglicher Mechanismus ist in US 5,412,035 A1 beschrieben, ohne die Erfindung hierauf einschränken zu wollen.

In einer weiteren vorteilhaften Ausführung ist der Trennmechanismus in einer weiteren Lage des Schichtverbunds verwirklicht, die dann eine Grenzschicht zur strukturierten Oberfläche des Wafers bildet. Hier können alle dem Fachmann bekannten Trennmittel wie zum Beispiel Wachse, Fette, Öle, fluorierte Polymere oder Silikone zum Einsatz kommen. In einer besonders bevorzugten Ausführung ist diese Schicht dünner als 1 µm, insbesondere dünner als 100 nm.

Als Trennschicht wirkt weiterhin bevorzugt eine Schicht, die zumindest reich an Partikeln ist, aber auch nahezu ausschließlich aus Partikeln bestehen kann, wobei die Partikel idealerweise keine Wechselwirkung mit der Substratoberfläche eingehen, aber möglichst affin zur viskoelastischen Schicht sind. Um ein Einfließen der viskoelastischen Schicht in die Strukturen der Substratoberfläche zu erleichtern, ist es besonders vorteilhaft, wenn diese Partikel in zumindest einer Dimension Abmessungen unterhalb von 100 nm aufweisen. Geeignete Partikel sind zum Beispiel gefällte oder pyrogene Silikate, die auch oberflächenmodifiziert sein können, Polymer- oder Glaskugeln, Schichtsilikate natürlichen oder synthetischen Ursprungs, Nanopartikel aus Silica (zum Beispiel Clariant Highlink OG) oder Metalloxiden (zum Beispiel Byk-Chemie Nanobyk-Serie), ohne durch diese Listung die Auswahl einschränken zu wollen.

Letzterer Aufbau der Trennschicht ist über diese Erfindung hinaus auch in vielen anderen Aufgabenstellungen vorteilhaft einsetzbar. Das Verfahren der Trennung durch die Verwendung von Nanopartikeln als Trennschicht ist unabhängig vom hier beschriebenen erfindungsgemäßen Verfahren einsetzbar.

Vorteilhaft kann es weiterhin sein, die Materialien des Schichtmaterials so auszuwählen, dass es sehr geringe oder keine Reaktionen im Vakuum - zum Beispiel durch Ausgasen - zeigt. Für Beschichtungsprozesse ist es vorteilhaft, wenn das eingesetzte Schichtmaterial eine hohe Wärmleitfähigkeit aufweist und somit das gezielte Erwärmen des Substrats, zum Beispiel des Wafers, zulässt oder die Wärme gezielt abführt. Diese Eigenschaft kann beispielhaft durch das Zufügen geeigneter Füllstoffe erlangt werden. Weiterhin ist es häufig vorteilhaft, das Schichtmaterial so auszuwählen, dass es in seinem Verhalten bei Temperaturschwankungen an das Substratmaterial angepasst ist, zum Beispiel indem Substratmaterial und Schichtmaterial so gewählt werden, dass sie sehr ähnliche Wärmeausdehnungskoeffizienten besitzen (zum Beispiel Verhältnis Wärmeausdehnungskoeffizient Schichtmaterial : Wärmeausdehnungskoeffizient Wafer liegt vorzugsweise im Bereich von 0,9 bis 1,1).

Das erfindungsgemäß verwendete Schichtmaterial löst derzeitige Probleme bei der Herstellung sehr dünner Wafer und deren Rückseitenbehandlung.

In einer bevorzugten Ausführung des Verfahrens findest das Einbringen von Energie und das Auffließen des Schichtmaterials auf die Waferoberfläche in einer Bondingpresse, wie sie zum Beispiel von der Firma EVG zur Verfügung gestellt wird, statt. Dadurch kann eine exzellente Planparallelität der Waferrückseite mit der der Waferoberfläche abgewandten Seite des Schichtmaterials erreicht werden.

Besonders bevorzugt findet dieser Verfahrensschritt im Vakuum statt. Damit werden Gaseinschlüsse zwischen Schichtmaterial und Wafervorderseite vermieden.

Der Wafer, bei dem es sich auch um einen Wafer handeln kann, der auf der Wafervorderseite (der strukturierten Seite) bereits vor dem Dünnungprozess mittels Schleifen und/oder Ritzen und/oder chemischen Ätzen und/oder Plasmaätzen von Gräben und/oder anderen Strukturen so strukturiert wurde, dass diese Strukturen während eines sich anschließenden Dünnungsprozesses mittels mechanischer und/oder chemischer Verfahren (zum Beispiel Ätzen) freigelegt werden und somit dabei eine Vereinzelung des Wafers stattfindet, wird in einer weiteren bevorzugten Variante des Verfahrens vor dem Abdünnen (Materialabtrag auf der Rückseite) auf der Vorderseite mit einer Trennschicht überzogen. Diese Trennschicht wird hierbei vorzugsweise mittels CVD Verfahren aufgebracht. Bei dieser Trennschicht kann es sich beispielhaft um eine plasmapolymere Beschichtung handeln, wie sie am Fraunhofer Institut für Fertigungstechnik und Angewandte Materialforschung in Bremen entwickelt wurde (siehe WO 2004/051708 A2). Es ist möglich, dass die Trennschicht in ihrer vollen Stärke durch den CVD-Prozess und/oder durch einen anderen vakuumtechnischen Prozess erzielt wird und/oder durch (gegebenenfalls vorheriges) Auftragen eines geeigneten Materials unterstützt und/oder erzielt wird. Vorzugweise werden hierbei Trennschichtdicken von 1 bis 1000 nm, bevorzugt 50 bis 200 nm eingestellt. Die Schichtdicke kann aber auch kleiner oder größer sein.

Bestandteil des Wafers kann, so ist der Begriff Wafer im Rahmen dieses Textes zu verstehen, auch eine Passivierungsschicht an der Wafervorderseite sein, und zwar bevorzugt dann, wenn der Wafer elektronische Bauelemente umfasst. Eine solche Passivierungsschicht (soweit vorhanden) befindet sich direkt im Kontakt mit der Schicht des Wafers, die die elektronischen Bauelemente trägt.

Das Abdünnen kann im erfindungsgemäßen Verfahren beispielsweise chemisch (Ätzen) und/oder mechanisch erfolgen.

Dabei wird das Verringern der Haftung des Schichtmaterials erreicht durch Bestrahlung mit elektromagnetischen Wellen, thermische Einwirkung, chemische Einwirkung und/oder mechanische Einwirkung. Die thermische Einwirkung kann dabei aus Erhitzen oder Abkühlen oder beiden Vorgängen bestehen.

Bevorzugt ist dabei ein erfindungsgemäßes Verfahren, in dem das Schichtmaterial mechanisch von der Trägerschicht oder dem Wafer oder den Teilen des Wafers enthaftet wird.

Zum Ablösen des Wafers wird vorzugsweise auf die Rückseite des Wafers eine (weitere) Folie (zum Beispiel Blue Tape, Dicing Tape) aufgebracht und anschließend das vorderseitig aufgebrachte erfindungsgemäße Schichtmaterial abgezogen. Beim Ablösen dieser Schicht kann es vorteilhaft sein, dass hierbei mechanische Vorrichtungen zur Anwendung kommen, die das Abziehen erleichtern. Insbesondere aber erleichtert eine im Schichtmaterials enthaltene oder zwischen Waferoberfläche und Schichtmaterial befindliche Trennschicht das Ablösen.

Die Erfindung ermöglicht die Realisierung wesentlicher technologischer Vorteile in der Fertigung und der Handhabung von Wafern bei der Herstellung von elektrischen Bauelementen, ICs, Sensoren usw. Mit dem erfindungsgemäßen Schichtmaterial und dem erfindungsgemäßen Verfahren wird die Fertigung vereinfacht und kostengünstiger gestaltet. Weiterhin können geringere Waferscheibendicken einfacher, wirtschaftlicher und sicherer realisiert werden.

Über die gegenwärtig in Anwendung befindlichen Trägerlösungen (Träger in Form von Folien oder anderen Schichtsystemen zum Beispiel aus Glas in Verbindung mit Wachs) hinaus ergeben sich Vorteile insbesondere bei Verfahren zur Rückseitenbeschichtung von dünnen Wafern, insbesondere wenn diese Beschichtungen im Vakuum stattfinden und/oder unter thermischer Belastung erfolgen. Hierbei wird das Handling der dünnen Wafer oder der bereits vereinzelten Bauelemente dadurch vereinfacht, dass das aufgebrachte Schichtmaterial den Wafer und/oder die vereinzelten Waferteile fixiert und/oder mechanisch unterstützt. Falls die Waferoberfläche ausreichende topografische Bedingungen besitzt, werden die vereinzelten Teile des Wafers auch hierdurch fixiert.

Dieser Effekt kann auch erzielt und/oder unterstützt werden, wenn zum Zwecke der Vereinzelung eine vorderseitige Strukturierung der Waferoberfläche durchgeführt wurde (Dicing before Grinding). In die hierbei entstehenden Strukturen wird dann nämlich in der Folge das erfindungsgemäße Schichtmaterial eingebracht und eine mechanische Verankerung der nachfolgend vereinzelten Waferteile erzielt.

Ein weiterer Vorteil ist, dass ein (vorderseitig) aufgebrachtes erfindungsgemäßes Schichtmaterial die Topographie der Waferoberfläche sehr gut und wohl besser als die derzeit in Anwendung befindlichen Folien schützen kann. Das nicht erwünschte Durchdrücken von Erhebungen auf der Waferoberfläche während der mechanischen Dünnungsverfahren kann deshalb vermindert oder sogar ausgeschlossen werden.

Ein weiterer Vorteil ist, dass das Schichtmaterial in einem einzelnen Arbeitsgang von einem Blatt oder einer Rolle aufgebracht werden kann, ohne dass Verschmutzungen durch zum Beispiel überquellende flüssige Materialien auftreten und ohne problematische Dickenschwankungen bei Beschichtungsprozessen mit Fluiden.

Die Erfindung wird im Folgenden durch Experimente sowie Beispiele beschrieben, ohne sich durch die Wahl der untersuchten Proben unnötig beschränken zu wollen.

Folgende Testmethoden wurden angewendet:
- Der Schubspannungszeitrampentest (Stress Ramp Test, Test A)
   Dieser Test wird unter Torsion in einem schubspannungsgesteuerten Rheometer vom Typ DSR der Firma Rheometrics mit einer Schubspannungsrampe von 100 Pa/min bei Raumtemperatur durchgeführt, wobei eine Platte-Platte-Geometrie mit einem Plattendurchmesser von 25 mm verwendet wird. Einzelheiten sind in Brummer (siehe oben) beschrieben.
- Oszillatorisches Scherexperiment: Dynamisch mechanische Analyse (DMA, Test B)
   Der Test dient der Untersuchung rheologischer Eigenschaften und ist in Pahl (siehe oben) ausführlich beschrieben. Der Test wird in einem schergeschwindigkeitskontrollierten Rheometer der Firma Ares unter Torsionsbelastung gefahren, wobei eine Platte-Platte-Geometrie mit einem Plattendurchmesser von 25 mm verwendet wird. Temperatur und Frequenz werden bei den Messergebnissen jeweils angegeben.
- Thermogravimetrische Analyse (TGA, Test C)
   Der Test dient der Bestimmung der Temperaturbeständigkeit. Die Probe wird unter Inertgasatmosphäre mit einer Rate von 10 °C/min aufgeheizt und gleichzeitig gewogen Der Gewichtsverlust wird über der Temperatur aufgetragen. Gewichtsverlust unterhalb von 150 °C wird in der Regel dem Ausgasen von Wasser, Restlösemitteln oder Restmonomeren zugeordnet, Gewichtsverlust oberhalb von 150 °C in der Regel einem thermischen Abbau der Probe.
- Bestimmung des Gelwerts (Test D)
   Die sorgfältig getrockneten lösungsmittelfreien Klebstoffproben werden in ein Vliestütchen aus Polyethylen (Tyvek-Vlies) eingeschweißt. Aus der Differenz der Probengewichte vor der Extraktion und nach der Extraktion durch Toluol wird der Gelwert, also der nicht in Toluol lösliche Gewichtsanteil des Polymers bestimmt.

### Beispiel 1

Es wurde die Silicon-Masse PSA 518 von GE Bayer Silicones mit 5 Gew.-% Aerosil R202 (Degussa) und 5 Gew.-% Benzoylperoxid (BPO) vermischt. Diese Masse wurde mit einem Masseauftrag von 300 g/m² auf eine 127 µm dicke Kapton 500HN Folie der Firma DuPont ausgestrichen und bei einer Temperatur von 60 °C getrocknet, so dass das BPO noch nicht zerfiel. Die Masse wurde danach mit einem fluorsilikonbeschichteten Folienliner der Firma Loparex abgedeckt.

Das so hergestellte Klebeband zeigte eine ausgezeichnete Lagerstabilität auf einer Rolle bei Raumtemperatur. Ausfließen der Masse aus der Rolle war über einen Zeitraum von 3 Monaten nicht zu beobachten.

Test A zeigte eine Fließgrenze für die Masse von 2400 Pa.

Test B zeigte eine komplexe Viskosität eta* bei einer Frequenz von 0.01 s⁻¹ und einer Applikationstemperatur von 160 °C von 20000 Pas

Das Klebeband wurde auf eine bereits strukturierte Waferoberfläche mit Bumps appliziert. Der Wafer war dabei mit einer ca. 50 nm dicken Releaseschicht aus Siliconöl des Typs AK 50 der Firma Wacker-Chemie beschichtet. Unter einer Vakuumpresse wurde das Klebeband bei einem Druck von 300 kPa angepresst. Dabei wurde die Presse auf eine Temperatur von 160 °C beheizt, so dass das Material vernetzte.

Beim Abziehen des Klebebandes vom Wafer zeigte dieses genügend Kohäsion, so dass es rückstandsfrei entfernt werden konnte.

Mittels Test C wurde die Temperaturstabilität nach der Vernetzung untersucht: Eine beginnende Degradation zeigte sich erst ab einer Temperatur von 310 °C

Test D zeigte einen Gelwert von 52 %.

### Beispiel 2

Es wurde die Silicon-Masse ELASTOSIL® R 830 18/45 von Wacker Silicones mit 1 Gew.-% Härter C6 (2,5-bis-(t-butylperoxy)-2,5-dimethyl hexane, 45 Gew.-% in silicone rubber) und 15 Gew.-% Aerosil R202 (Degussa) vermischt. Diese Masse wurde mit einem Masseauftrag von 200 g/m² auf eine 127 µm dicke Kapton 500HN Folie der Firma DuPont im Kalanderverfahren bei einer Temperatur von 60 °C aufgetragen, so dass die Vernetzungsreaktion nicht ansprang. Die Masse wurde danach mit einem fluorsilikonbeschichteten Folienliner der Firma Loparex abgedeckt.

Das so hergestellte Klebeband zeigte eine ausgezeichnete Lagerstabilität über einen Zeitraum von 2 Monaten auf einer Rolle bei Raumtemperatur. Zusammenfließen der einzelnen Lagen der Rolle war nicht zu beobachten.

Test A zeigte eine Fließgrenze für die Masse von 5300 Pa.

Test B zeigte eine komplexe Viskosität eta* bei einer Frequenz von 0.01 s⁻¹ und einer Applikationstemperatur von 170 °C von 100 Pas

Das Klebeband wurde auf eine bereits strukturierte Waferoberfläche mit Bumps appliziert. Der Wafer war dabei mit einer ca. 50 nm dicken Releaseschicht aus Siliconöl des Typs AK 50 der Firma Wacker-Chemie beschichtet. Unter einer Vakuumpresse wurde das Klebeband bei einem Druck von 300 kPa angepresst. Dabei wurde die Presse auf eine Temperatur von 170 °C beheizt, so dass das Material vernetzte.

Beim Abziehen des Klebebandes vom Wafer zeigte dieses genügend Kohäsion, so dass es rückstandsfrei entfernt werden konnte.

Mittels Test C wurde die Temperaturstabilität nach der Vernetzung untersucht: Eine beginnende Degradation zeigte sich erst ab einer Temperatur von 360 °C

Test D zeigte einen Gelwert von 98 %.

### Beispiel 3

Es wurde ein statistisches Polyacrylat-Copolymer nach dem Fachmann bekannten Verfahren mit folgender Zusammensetzung hergestellt:
20 Gew.-% Methylacrylat
7 Gew.-% Acrylsäure
64 Gew.-% Ethylhexylacrylat
9 Gew.-% Hydroxyethylmethacrylat

Das gewichtsmittlere Molekulargewicht M_{w} betrug 870000 g/mol.

In einer 50 %igen Lösung des Copolymers in Aceton wurden 11 % Aerosil R202 der Firma Degussa sowie 5 % eines blockierten Isocyanats (Typ Trixene BI 7950 der Firma Baxenden) jeweils bezogen auf den Feststoffgehalt zugemischt.

Diese Masse wurde mit einem Masseauftrag von 300 g/m² auf eine 127 µm dicke Kapton 500HN Folie der Firma DuPont im Streichverfahren bei einer Trocknungstemperatur von 80 °C aufgetragen, so dass die Vernetzungsreaktion nicht ansprang. Die Masse wurde danach mit einem silikonbeschichteten Folienliner der Firma Siliconature abgedeckt.

Das so hergestellte Klebeband zeigte über eine Zeitraum von 3 Monaten eine ausgezeichnete Lagerstabilität auf einer Rolle bei Raumtemperatur. Zusammenfließen der einzelnen Lagen der Rolle war nicht zu beobachten.

Test A zeigte eine Fließgrenze für die Masse von 4600 Pa.

Test B zeigte eine komplexe Viskosität eta* bei einer Frequenz von 0.01 s⁻¹ und einer Applikationstemperatur von 140 °C von 35000 Pas

Das Klebeband wurde auf eine bereits strukturierte Waferoberfläche mit Bumps appliziert. Der Wafer war dabei mit einer ca. 50 nm dicken Releaseschicht aus Siliconöl des Typs AK 50 der Firma Wacker-Chemie beschichtet. Unter einer Vakuumpresse wurde das Klebeband bei einem Druck von 300 kPa angepresst. Dabei wurde die Presse auf eine Temperatur von 140 °C beheizt, so dass das Material vernetzte.

Beim Abziehen des Klebebandes vom Wafer zeigte dieses genügend Kohäsion, so dass es rückstandsfrei entfernt werden konnte.

Mittels Test C wurde die Temperaturstabilität nach der Vernetzung untersucht: Eine beginnende Degradation zeigte sich erst ab einer Temperatur von 270 °C

Test D zeigte einen Gelwert von 74 %.

### Beispiel 4

Es wurde ein statistisches Polyacrylat-Copolymer nach dem Fachmann bekannten Verfahren mit folgender Zusammensetzung hergestellt:
20 Gew.-% Methylacrylat
7 Gew.-% Acrylsäure
64 Gew.-% Butylacrylat
9 Gew.-% Hydroxyethylmethacrylat

Das gewichtsmittlere Molekulargewicht M_{w} betrug 790000 g/mol.

In einer 50 %igen Lösung in Aceton wurden 11 % Aerosil R202 der Firma Degussa sowie 5% eines blockierten Isocyanats (Typ Trixene BI 7950 der Firma Baxenden) jeweils bezogen auf den Feststoffgehalt zugemischt.

Diese Masse wurde mit einem Masseauftrag von 300 g/m² auf eine 127 µm dicke Kapton 500HN Folie der Firma DuPont im Streichverfahren bei einer Trocknungstemperatur von 80 °C aufgetragen, so dass die Vernetzungsreaktion nicht ansprang. Die Masse wurde danach mit einem silikonbeschichteten Folienliner der Firma Siliconature abgedeckt.

Das so hergestellte Klebeband zeigte über eine Zeitraum von 3 Monaten eine ausgezeichnete Lagerstabilität auf einer Rolle bei Raumtemperatur. Zusammenfließen der einzelnen Lagen der Rolle war nicht zu beobachten.

Test A zeigte eine Fließgrenze für die Masse von 5100 Pa.

Test B zeigte eine komplexe Viskosität eta* bei einer Frequenz von 0.01 s-1 und einer Applikationstemperatur von 140 °C von 26000 Pas

Das Klebeband wurde auf eine bereits strukturierte Waferoberfläche mit Bumps appliziert. Der Wafer war dabei mit einer ca. 50 nm dicken Releaseschicht aus Siliconöl des Typs AK 50 der Firma Wacker-Chemie beschichtet. Unter einer Vakuumpresse wurde das Klebeband bei einem Druck von 300 kPa angepresst. Dabei wurde die Presse auf eine Temperatur von 140 °C beheizt, so dass das Material vernetzte.

Beim Abziehen des Klebebandes vom Wafer zeigte dieses genügend Kohäsion, so dass es rückstandsfrei entfernt werden konnte.

Mittels Test B wurde die Temperaturstabilität nach der Vernetzung untersucht: Eine beginnende Degradation zeigte sich erst ab einer Temperatur von 290°C

Test D zeigte einen Gelwert von 76 %.

Es zeigt sich hiermit, dass durch den Einsatz linearer Reste R₂ (s.o.) die Temperaturstabilität gesteigert werden kann.

### Beispiel 5

In einer 50 %igen Lösung in Toluol wurden 95 % Epofriend A 1010 der Firma Daicel sowie 2 % Dyhard 100S der Firma Degussa (Dicyandiamid) jeweils bezogen auf den Feststoffgehalt zusammengemischt.

Diese Masse wurde mit einem Masseauftrag von 300 g/m² auf eine 127 µm dicke Kapton 500HN Folie der Firma DuPont im Streichverfahren bei einer Trocknungstemperatur von 110 °C aufgetragen, so dass die Vernetzungsreaktion nicht ansprang.

Das so hergestellte Schichtmaterial ist nicht haftklebrig und zeigt keinerlei Tendenz zum Fließen, was aufgrund der physikalischen Vernetzung des blockcopolymeren Synthesekautschuks auch nicht zu erwarten ist. Die Lagerstabilität einer Rolle bei Raumtemperatur dürfte somit kaum begrenzt sein.

Test A zeigte eine Schubspannung, die den Messbereich des Geräts überschritt und somit mehr als 50000 Pa betrug.

Test B zeigte eine komplexe Viskosität eta* bei einer Frequenz von 0.01 s-1 und einer Applikationstemperatur von 200 °C von 10 Pas

Das Schichtmaterial wurde auf eine bereits strukturierte Waferoberfläche mit Bumps appliziert. Der Wafer war dabei mit einer ca. 50 nm dicken Releaseschicht aus Siliconöl des Typs AK 50 der Firma Wacker-Chemie beschichtet. Unter einer Vakuumpresse wurde das Klebeband bei einem Druck von 100 kPa angepresst. Dabei wurde die Presse auf eine Temperatur von 200 °C beheizt, so dass das Material vernetzte.

Beim Abziehen des Schichtmaterials vom Wafer zeigte dieses genügend Kohäsion, so dass es rückstandsfrei entfernt werden konnte.

Mittels Test B wurde die Temperaturstabilität nach der Vernetzung untersucht: Eine beginnende Degradation zeigte sich erst ab einer Temperatur von 310°C

### Beispiel 6

Eine Mischung aus 85 % Kraton™ FG 1901 (maleinsäureanhydridmodifiziertes Styrol-Ethylenbutylen-Styrol-Blockcopolymer mit 30% Blockpolystyrol und ca. 2% Maleinsäureanhydrid) und 15% Epofriend™ A 1010 (epoxidiertes Styrol-Butadien-Styrol-Blockcopolymer mit 40% Blockcpolystyrol) wurden in Toluol gelöst.

Diese Masse wurde mit einem Masseauftrag von 300 g/m² auf eine 127 µm dicke Kapton 500HN Folie der Firma DuPont im Streichverfahren bei einer Trocknungstemperatur von 110 °C aufgetragen, so dass die Vernetzungsreaktion nicht ansprang.

Das so hergestellte Schichtmaterial ist nicht haftklebrig und zeigt keinerlei Tendenz zum Fließen, was aufgrund der physikalischen Vernetzung des blockcopolymeren Synthesekautschuks auch nicht zu erwarten ist. Die Lagerstabilität einer Rolle bei Raumtemperatur dürfte somit kaum begrenzt sein.

Test A zeigte eine Schubspannung, die den Messbereich des Geräts überschritt und somit mehr als 50000 Pa betrug.

Test B zeigte eine komplexe Viskosität eta* bei einer Frequenz von 0.01 s-1 und einer Applikationstemperatur von 200 °C von 10 Pas

Das Schichtmaterial wurde auf eine bereits strukturierte Waferoberfläche mit Bumps appliziert. Der Wafer war dabei mit einer ca. 50 nm dicken Releaseschicht aus Siliconöl des Typs AK 50 der Firma Wacker-Chemie beschichtet. Unter einer Vakuumpresse wurde das Klebeband bei einem Druck von 100 kPa angepresst. Dabei wurde die Presse auf eine Temperatur von 200 °C beheizt, so dass das Material vernetzte.

Beim Abziehen des Schichtmaterials vom Wafer zeigte dieses genügend Kohäsion, so dass es rückstandsfrei entfernt werden konnte.

Mittels Test B wurde die Temperaturstabilität nach der Vernetzung untersucht: Eine beginnende Degradation zeigte sich erst ab einer Temperatur von 340°C

### Beispiel 7 (Vergleichsbeispiel)

Es wurde das Klebeband aus Beispiel 1 verwendet.

Das Schichtmaterial wurde auf eine bereits strukturierte Waferoberfläche mit Bumps appliziert. Der Wafer war dabei nicht mit einem Trennmittel beschichtet. Unter einer Vakuumpresse wurde das Klebeband bei einem Druck von 100 kPa angepresst. Dabei wurde die Presse auf eine Temperatur von 160 °C beheizt, so dass das Material vernetzte.

Ein Abziehen des Schichtmaterials vom Wafer war von Hand nicht möglich.

### Beispiel 8

Es wurde das Klebeband aus Beispiel 1 verwendet. Der Liner wurde ausgedeckt. Die Oberfläche der Siliconmasse wurde mit einer Dispersion aus 15 % Silica-Nanopartikeln in Methoxypropylacetat (Nanopol XP21/1264 der Firma Hanse-Chemie) im Rasterwalzenauftragsverfahren beschichtet und bei 100 °C getrocknet. Der Masseauftrag nass betrug dabei 0.5 g/m².

Die Oberfläche war danach nicht mehr haftklebrig.

Das Schichtmaterial wurde auf eine bereits strukturierte Waferoberfläche mit Bumps appliziert. Der Wafer war dabei nicht mit einem Trennmittel beschichtet. Unter einer Vakuumpresse wurde das Klebeband bei einem Druck von 100 kPa angepresst. Dabei wurde die Presse auf eine Temperatur von 160 °C beheizt, so dass das Material vernetzte.

Test A zeigte weiterhin eine Fließgrenze für die Masse von 2400 Pa.

Test B zeigte eine komplexe Viskosität eta* bei einer Frequenz von 0.01 s⁻¹ und einer Applikationstemperatur von 130 °C von 30000 Pas.

Ein Abziehen des Schichtmaterials vom Wafer von Hand war möglich.

Dieses Beispiel zeigt, dass es vorteilhaft möglich ist, eine Trennschicht in das Schichtmaterial zu integrieren.

## Patentansprüche

1. Verfahren zum Bearbeiten eines Wafers, der bevorzugt auf einer Seite (Vorderseite) Bauelemente trägt, **gekennzeichnet durch** die folgenden Schritte:
• Applizieren eines polymeren Schichtmaterials auf die Vorderseite, wobei das polymere Schichtmaterial zumindest eine viskoelastische Schicht mit folgenden Eigenschaften umfasst
■ das Erreichen einer Schubspannung von zumindest 1000 Pa im Schubspannungszeitrampentest bei einer Temperatur von 20 °C und einer Schubspannungsrampe von 100 Pa/min, ohne dass das viskoelastische Material anfängt zu fließen,
■ eine komplexe Viskosität eta* von weniger als 50000 Pas im oszillatorischen Scherexperiment (DMA) bei der Applikationstemperatur und einer Frequenz von 0.01 s⁻¹,
■ die Fähigkeit zur Erhöhung der Kohäsion und damit Absenkung der Fließfähigkeit **durch** Vernetzung der Schicht,
■ die zumindest teilweise Gummielastizität der viskoelastischen Schicht nach der Vernetzung zur rückstandfreien späteren Abtrennung von der Oberfläche nach der Vernetzung, **gekennzeichnet durch** einen tan delta im oszillatorischen Scherexperiment bei der Trenntemperatur und einer Frequenz von 100 s⁻¹ unterhalb von 1,
• Herabsetzen der Viskosität der zumindest einen viskoelastischen Schicht im Schichtverbund **durch** Einbringen von Energie, so dass ein Auffließen auf die Wafervorderseite und somit eine zumindest teilweise stoffschlüssige Verbindung damit stattfindet
• Vernetzen der zumindest einen viskoelastischen Schicht
• Abdünnen und/oder Beschichten und/oder Behandeln der Waferrückseite
• Ablösen der viskoelastischen Schicht nach der Bearbeitung des Wafers

2. Verfahren nach Anspruch 1, **dadurch gekennzeichnet, dass**
das das Erreichen einer Schubspannung von zumindest 1000 Pa im Schubspannungszeitrampentest durch die Zugabe von Füllstoffen erreicht werden, bevorzugt durch Füllstoffe, die aufgrund von Teilchenwechselwirkungen in der Lage sind, ein Füllstoffnetzwerk auszubilden, besonders bevorzugt durch pyrogene Kieselsäuren, Schichtsilikate, Nanotubes oder Ruße.

3. Verfahren nach Anspruch 1 oder 2, **dadurch gekennzeichnet, dass**
das das Erreichen einer Schubspannung von zumindest 1000 Pa im Schubspannungszeitrampentest durch die Ausbildung eines Gelnetzwerks innerhalb des polymeren Schichtmaterials erreicht wird.

4. Verfahren nach zumindest einem der Ansprüche 1 bis 3, **dadurch gekennzeichnet, dass**
geringe Viskosität während der Applikation durch Erhöhung der Temperatur und/oder dem Aufbringen von Scher- und/oder Dehnkräften erreicht wird.

5. Verfahren nach Anspruch 4, **dadurch gekennzeichnet, dass**
die Scher- und/oder Dehnkräfte oszillierend aufgebracht werden.

6. Verfahren nach zumindest einem der vorherigen Ansprüche, **dadurch gekennzeichnet, dass**
das Auffließen auf die strukturierte Oberfläche des Wafers durch Andrücken unterstützt wird.

7. Verfahren nach zumindest einem der vorherigen Ansprüche, **dadurch gekennzeichnet, dass**
das mindestens eine viskoelastische Material einen Vernetzungsgrad aufweist, der mindestens einem Gelwert von 50 %, insbesondere von mindestens 75 % entspricht.

8. Verfahren nach zumindest einem der vorherigen Ansprüche, **dadurch gekennzeichnet, dass**
dem viskoelastischen Material Vernetzer und/oder Promotoren zur Vernetzung beigemischt sind, insbesondere durch UV-, Elektronenstrahlen oder thermisch anregbare Vernetzer und/oder Promotoren.

9. Verfahren nach zumindest einem der vorherigen Ansprüche, **dadurch gekennzeichnet, dass**
die viskoelastische Schicht eine Dicke von mehr als 100 µm, besonders bevorzugt mehr als 200 µm besitzt.

10. Verfahren nach zumindest einem der vorherigen Ansprüche, **dadurch gekennzeichnet, dass**
die zumindest eine viskoelastische Schicht, gemessen nach Test C, über zumindest eine Stunde beständig gegen eine Temperatur von mehr als 200 °C ist, bevorzugt mehr als 300 °C.

11. Verfahren nach zumindest einem der vorherigen Ansprüche, **dadurch gekennzeichnet, dass**
das Schichtmaterial zumindest eine weitere Schicht beinhaltet, die die viskoelastische Schicht zumindest einseitig abdeckt und als Release-Liner dient, welcher zumindest einseitig vor der Applikation auf die strukturierte Oberfläche des Wafers entfernt wird.

12. Verfahren nach zumindest einem der vorherigen Ansprüche, **dadurch gekennzeichnet, dass**
das Schichtmaterial eine Schicht beinhaltet, die als permanenter Träger der viskoelastischen Schicht dient.

13. Verfahren nach zumindest einem der vorherigen Ansprüche, **dadurch gekennzeichnet, dass**
das Schichtmaterial einen Trennmechanismus zur strukturierten Oberfläche des Wafers beinhaltet, der vorzugsweise in die viskoelastische Schicht integriert ist.

14. Verfahren zum Bearbeiten eines Wafers nach Anspruch 1, **dadurch gekennzeichnet, dass** das Einbringen von Energie und das Auffließen des Schichtmaterials auf die Waferoberfläche in einer Bondingpresse stattfinden, weiter bevorzugt im Vakuum.

## Claims

1. Process for processing a wafer which preferably carries components on one side (frontside), **characterized by** the following steps:
• applying a polymeric layer material to the frontside,
the polymeric layer material encompassing at least one viscoelastic layer with the following properties:
• the attainment of a shear stress of at least 1000 Pa in the shear stress ramp test at a temperature of 20°C with a shear stress ramp of 100 Pa/min, without the viscoelastic material beginning to flow,
• a complex viscosity eta* of less than 50 000 Pas in the oscillatory shear experiment (DMA) at the application temperature and at a frequency of 0.01 s⁻¹,
• the capacity to increase the cohesion and thus lower the fluidity by crosslinking of the layer,
• the at least partial elastomeric character of the viscoelastic layer after crosslinking for subsequent separation from the surface without residue after crosslinking, **characterized by** a tan delta in the oscillatory shear test at the separation temperature and at a frequency of 100 s⁻¹ of below 1,
• lowering the viscosity of the at least one viscoelastic layer in the layer assembly by introducing energy, so that there is flow onto the wafer's frontside and hence an at least partial physical bond thereto takes place
• crosslinking of the at least one viscoelastic layer
• thinning and/or coating and/or treatment of the wafer's backside
• detaching the viscoelastic layer after processing the wafer.

2. Process according to Claim 1, **characterized in that** the attainment of a shear stress of at least 1000 Pa in the shear stress ramp test is achieved through the addition of fillers, preferably through fillers which on account of particle interactions are capable of forming a filler network, more preferably through fumed silicas, phyllosilicates, nanotubes or carbon blacks.

3. Process according to Claim 1 or 2, **characterized in that** the attainment of a shear stress of at least 1000 Pa in the shear stress ramp test is achieved through the formation of a gel network within the polymeric layer material.

4. Process according to at least one of Claims 1 to 3, **characterized in that** low viscosity during the application is achieved by raising the temperature and/or by applying shearing forces and/or extensional forces.

5. Process according to Claim 4, **characterized in that** the shearing forces and/or extensional forces are applied oscillatingly.

6. Process according to at least one of the preceding claims, **characterized in that** the flow onto the structured surface of the wafer is supported by pressing.

7. Process according to at least one of the preceding claims, **characterized in that** the at least one viscoelastic material has a degree of crosslinking which corresponds at least to a gel value of 50%, more particularly of at least 75%.

8. Process according to at least one of the preceding claims, **characterized in that** crosslinkers and/or crosslinking promoters have been admixed to the viscoelastic material, more particularly crosslinkers and/or promoters which are excitable by means of UV rays, by means of electron beams or thermally.

9. Process according to at least one of the preceding claims, **characterized in that** the viscoelastic layer possesses a thickness of more than 100 µm, more preferably more than 200 µm.

10. Process according to at least one of the preceding claims, **characterized in that** the at least one viscoelastic layer, measured by test C, is resistant for at least one hour to a temperature of more than 200°C, preferably more than 300°C.

11. Process according to at least one of the preceding claims, **characterized in that** the layer material includes at least one further layer which covers the viscoelastic layer on at least one side and serves as a release liner which is removed at least on one side prior to application to the structured surface of the wafer.

12. Process according to at least one of the preceding claims, **characterized in that** the layer material includes a layer which serves as a permanent carrier of the viscoelastic layer.

13. Process according to at least one of the preceding claims, **characterized in that** the layer material includes a release mechanism in relation to the structured surface of the wafer, said mechanism preferably being integrated in the viscoelastic layer.

14. Process for processing a wafer according to Claim 1, **characterized in that** the introduction of energy and the flow of the layer material onto the wafer surface take place in a bonding press, more preferably in a vacuum.

## Revendications

1. Procédé pour l'usinage d'une tranche de semiconducteur qui présente de préférence des modules sur une face (face avant), **caractérisé par** les étapes suivantes :
- application d'un matériau polymère à couches sur la face avant, le matériau polymère à couches comprenant au moins une couche viscoélastique présentant les propriétés suivantes
- l'obtention d'une contrainte de cisaillement d'au moins 1000 Pa dans le test de la rampe en fonction du temps de la contrainte de cisaillement à une température de 20°C et à une rampe de contrainte de cisaillement de 100 Pa/min, sans que le matériau viscoélastique ne commence à s'écouler,
- une viscosité complexe eta* de moins de 50 000 Pa.s dans l'expérience de cisaillement oscillatoire (analyseur dynamique mécanique-DMA) à la température d'application et à une fréquence de 0,01 s⁻¹,
- l'aptitude à augmenter la cohésion et donc la diminution de l'aptitude à l'écoulement par réticulation de la couche,
- une élasticité caoutchouteuse au moins partielle de la couche viscoélastique après la réticulation pour une séparation ultérieure, sans résidus, de la surface après la réticulation, **caractérisée par** un tan delta dans l'expérience de cisaillement oscillatoire à la température de séparation et une fréquence de 100 s⁻¹ inférieur à 1,
- diminution de la viscosité de ladite au moins une couche viscoélastique dans le composite à couches par introduction d'énergie, de telle sorte qu'il se produit un étalement sur la face avant de la tranche et donc un assemblage au moins partiel par liaison de matière avec celle-ci,
- réticulation de ladite au moins une couche viscoélastique
- amincissement et/ou revêtement et/ou traitement de la face arrière de la tranche
- décollement de la couche viscoélastique après l'usinage de la tranche.

2. Procédé selon la revendication 1, **caractérisé en ce que** l'obtention d'une contrainte de cisaillement d'au moins 1000 Pa dans le test de la rampe en fonction du temps de la contrainte de cisaillement est réalisée par l'addition de charges, de préférence des charges qui sont en mesure, en raison d'interactions entre les particules, de former un réseau de charges, de manière particulièrement préférée par des silices pyrogènes, des silicates à couches, des nanotubes ou des suies.

3. Procédé selon la revendication 1 ou 2, **caractérisé en ce que** l'obtention d'une contrainte de cisaillement d'au moins 1000 Pa dans le test de la rampe en fonction du temps de la contrainte de cisaillement est réalisée par la formation d'un réseau de gel dans le matériau polymère à couches.

4. Procédé selon au moins l'une quelconque des revendications 1 à 3, **caractérisé en ce que** la faible viscosité pendant l'application est obtenue par augmentation de la température et/ou par application de forces de cisaillement et/ou d'allongement.

5. Procédé selon la revendication 4, **caractérisé en ce que** les forces de cisaillement et/ou d'allongement sont appliquées de manière oscillatoire.

6. Procédé selon au moins l'une quelconque des revendications précédentes, **caractérisé en ce que** l'étalement sur la surface structurée de la tranche est soutenu par une compression.

7. Procédé selon au moins l'une quelconque des revendications précédentes, **caractérisé en ce que** ledit au moins un matériau viscoélastique présente un degré de réticulation qui correspond au moins à une valeur de gel de 50%, en particulier d'au moins 75%.

8. Procédé selon au moins l'une quelconque des revendications précédentes, **caractérisé en ce que** des réticulants et/ou des promoteurs de réticulation sont mélangés au matériau viscoélastique, en particulier des réticulants et/ou des promoteurs excitables par des rayons UV, des rayons électroniques ou thermiquement excitables.

9. Procédé selon au moins l'une quelconque des revendications précédentes, **caractérisé en ce que** la couche viscoélastique présente une épaisseur de plus de 100 µm, de manière particulièrement préférée de plus de 200 µm.

10. Procédé selon au moins l'une quelconque des revendications précédentes, **caractérisé en ce que** ladite au moins une couche viscoélastique, mesurée selon le test C, résiste pendant au moins une heure à une température de plus de 200°C, de préférence de plus de 300°C.

11. Procédé selon au moins l'une quelconque des revendications précédentes, **caractérisé en ce que** le matériau à couches comporte au moins une autre couche, qui recouvre la couche viscoélastique au moins sur une face et qui sert de revêtement antiadhésif, qui est éliminé au moins sur une face avant l'application sur la surface structurée de la tranche.

12. Procédé selon au moins l'une quelconque des revendications précédentes, **caractérisé en ce que** le matériau à couches comporte une couche qui sert de support permanent de la couche viscoélastique.

13. Procédé selon au moins l'une quelconque des revendications précédentes, **caractérisé en ce que** le matériau à couches comporte un mécanisme de séparation pour la surface structurée de la tranche, qui est de préférence intégré dans la couche viscoélastique.

14. Procédé pour l'usinage d'une tranche selon la revendication 1, **caractérisé en ce que** l'introduction d'énergie et l'étalement du matériau à couches sur la surface de la tranche ont lieu dans une presse de collage, plus préférablement sous vide.
